Europäisches Patentamt

European Patent Office

Office européen des brevets

(11) Publication number:

**0 072 686**

**B1**

## (12) EUROPEAN PATENT SPECIFICATION

(45) Date of publication of patent specification: 30.07.86

(21) Application number: 82304299.9

(22) Date of filing: 13.08.82

(51) Int. Cl.⁴: **H 03 K 19/094,** H 03 K 5/02

(54) A buffer circuit including inverter circuitry.

(30) Priority: 13.08.81 JP 125981/81

(43) Date of publication of application:
23.02.83 Bulletin 83/08

(45) Publication of the grant of the patent:
30.07.86 Bulletin 86/31

(84) Designated Contracting States:
DE FR GB

(56) References cited:
DE-B-2 737 506
US-A-3 631 528
US-A-4 164 842

ELECTRONICS AND COMMUNICATIONS IN
JAPAN, vol. 60-C, no. 9, September 1977,
pages 102-109, Washington (USA); OSAMU
MITATO et al.: "Performance of logic LSIs using
short channel MOSFETs".

(73) Proprietor: FUJITSU LIMITED
1015, Kamikodanaka Nakahara-ku
Kawasaki-shi Kanagawa 211 (JP)

(72) Inventor: Suzuki, Yasuo
c/o Mr. Azuma 11-16, Shiratoridai
Midori-ku Yokohama-shi Kanagawa 227 (JP)
Inventor: Hirao, Hiroshi
Kogane-so 5 2223, Noborito
Tama-ku Kawasaki-shi Kanagawa 214 (JP)
Inventor: Nagasawa, Masanori
2-21, Tamanawa
Kamakura-shi Kanagawa 247 (JP)

(74) Representative: Fane, Christopher Robin King
et al
HASELTINE LAKE & CO. Hazlitt House 28
Southampton Buildings Chancery Lane
London, WC2A 1AT (GB)

## Description

The present invention relates to a buffer circuit including inverter circuitry, for driving a complementary metal-oxide semiconductor (C-MOS) inverter.

Generally, a conventional C-MOS inverter consists of a p-channel metal-oxide semiconductor (MOS) transistor (p-MOS) and an n-channel MOS transistor (n-MOS) connected in series between a power supply and a ground. In principle, no current flows from the power supply through the C-MOS inverter to the ground in a steady state. This is because when one of the p-MOS or n-MOS transistors is conductive (turned on), the other should be nonconductive (turned off). Therefore, there is no variation of the power supply voltage in the steady state.

During the transition period when the input of such a C-MOS inverter is inverted, however, there may be an instant when both transistors are conductive. At that instant, a large current flows through the C-MOS inverter. The large current causes a fluctuation in the power supply voltage which may be applied not only to the C-MOS inverter but also to an internal integrated circuit (IC) integrating the C-MOS inverter and to another external circuit. The momentary variation in the power supply voltage received by the internal IC or the external circuit as noise can cause error in circuit operation. Therefore, it is desirable to prevent such momentary large current during the above-mentioned transition period. This is especially true when the C-MOS inverter is used as an output circuit of, for example, a memory circuit.

A C-MOS inverter can be driven by a buffer circuit comprising first and second inverters, for respectively driving the p-MOS transistor and n-MOS transistor in the C-MOS inverter, each of which inverters has a pull-up portion and a pull-down portion connected in series with one another between first and second power supply lines. Each of these inverters has an output point between its pull-up portion and its pull-down portion, and the output points of the two inverters are connected respectively to drive the two transistors of the C-MOS inverter. Conventionally, in order to prevent large currents during the above-mentioned transition period, the mutual conductances (gm) of the transistors which constitute the buffer inverters are made different from each other. This makes the timing for driving the p-MOS transistor different from the timing for driving the n-MOS transistor. Such a system is known, for example, from US—A—3,631,528. However, it is somewhat difficult to manufacture the transistors in the buffer circuit to have exactly the right mutual conductances for obtaining the desired timing lag. Therefore, conventional buffer circuits may not prevent the momentary large current during the transition period of C-MOS inverters.

It is desirable to provide a buffer circuit, for driving a C-MOS inverter, which can prevent the simultaneous conduction of current through transistors which constitute a C-MOS inverter, thereby to prevent fluctuations of the power supply voltage applied to the C-MOS inverter.

Desirably such a buffer circuit provided at the output stage of a semiconductor memory circuit should prevent error operation of the semiconductor memory circuit due to fluctuation of the power supply voltage applied to the semiconductor memory circuit.

According to the present invention there is provided a buffer circuit, for driving a C-MOS inverter which comprises two transistors connected together in series,

the said buffer circuit comprising first and second inverters, for inverting an input signal and driving respectively the said two transistors of the C-MOS inverter, each of the said first and second inverters comprising a pull-up portion and a pull-down portion, connected in series with one another between first and second power supply lines, and having an output point between its pull-up portion and its pull-down portion, the said output point of the said first inverter being connected to a gate of one of the said two transistors of the C-MOS inverter, and the said output point of the said second inverter being connected to a gate of the other of the said two transistors of the C-MOS inverter,

characterised in that,

the said first inverter further comprises a switching transistor connected, in series with the said pull-down portion of that inverter, between the said second power supply line and the said output point of that inverter,

the said second inverter further comprises a switching transistor connected, in series with the said pull-up portion of that inverter, between the said first power supply line and the said output point of that inverter,

and the said buffer circuit further comprises a delay circuit which is connected to apply, to the switching transistors of the first and second inverters, respective control signals derived from the said input signal but delayed with respect thereto by a predetermined delay time such as to prevent simultaneous conduction of current through the said two transistors of the C-MOS inverter.

Reference will now be made by way of example, to the accompanying drawings, in which:

Fig. 1 is a circuit diagram illustrating a conventional buffer circuit for driving a C-MOS inverter;

Fig. 2 is a waveform diagram illustrating the relation between the input voltages and the output voltages of the buffer circuit in Fig. 1;

Fig. 3 is a curcuit diagram illustrating a buffer circuit for driving a C-MOS inverter according to an embodiment of the present invention;

Fig. 4 is a waveform diagram illustrating the relation between the input voltages and the output voltages of the buffer circuit in Fig. 3;

Fig. 5 is a circuit diagram illustrating an example of a delay circuit for use in the circuit of Fig. 3;

Fig. 6 is a circuit diagram illustrating a buffer circuit for driving a C-MOS inverter according to another embodiment of the present invention; and

Fig. 7 is a circuit diagram illustrating a buffer circuit for driving a C-MOS inverter according to still another embodiment of the present invention.

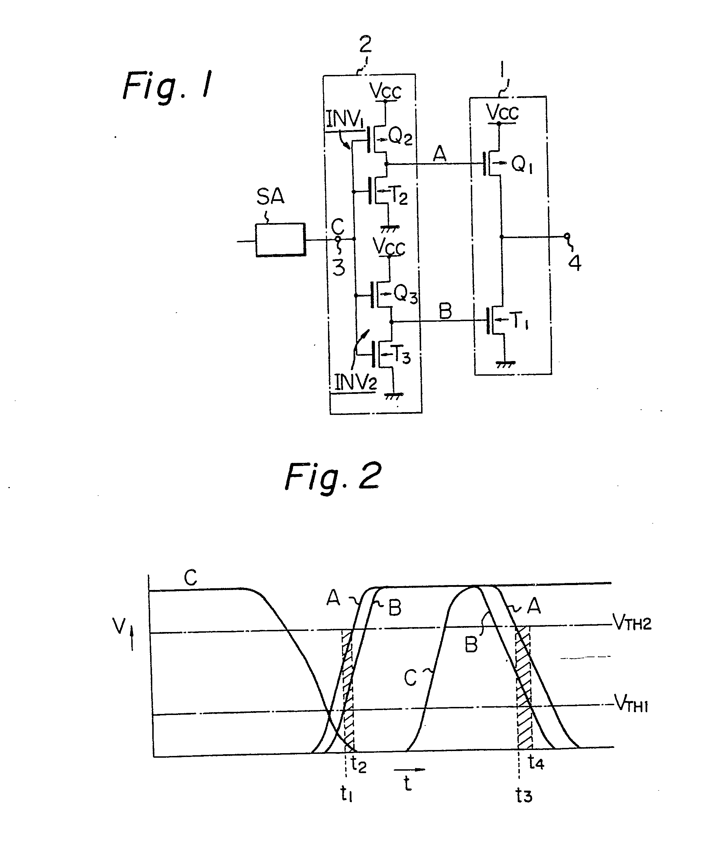

Before describing the embodiments of the present invention, a conventional example and its disadvantages will first be described with reference to Figs. 1 and 2. In Fig. 1, reference numeral 1 is a C-MOS inverter; 2 is a conventional buffer circuit for driving the C-MOS inverter 1; 3 is an input end of the buffer circuit 2; and 4 is an output end of the C-MOS inverter 1. Reference symbol SA represents a sense amplifier in a memory circuit. The C-MOS inverter 1 consists of a first p-MOS transistor $Q_1$ and a first n-MOS transistor $T_1$ connected in series between a power supply line $V_{cc}$ and a ground. The buffer circuit 2 consists of a first inverter $INV_1$ for driving the first p-MOS transistor $Q_1$ and a second inverter $INV_2$ for driving the first n-MOS transistor $T_1$. The first inverter $INV_1$ consists of a second p-MOS transistor $Q_2$ and a second n-MOS transistor $T_2$, which transistors respectively constitute a pull-up portion and a pull-down portion of the inverter $INV_1$ and are connected in series between the power supply line $V_{cc}$ and the ground. The second inverter $INV_2$ consists of a third p-MOS transistor $Q_3$ (pull-up portion) and a third n-MOS transistor $T_3$ (pull-down portion) connected in series between the power supply line $V_{cc}$ and the ground. The gates of the transistors in the buffer circuit 2 are commonly connected to the input end 3. The input end 3 is connected through the sense amplifier SA to a memory cell array (not shown). The connecting point between the p-MOS transistor $Q_2$ and the n-MOS transistor $T_2$, i.e., the output end of the first inverter $INV_1$, is connected to the gate of the first p-MOS transistor $Q_1$ in the C-MOS inverter 1. The connecting point between the p-MOS transistor $Q_3$ and the n-MOS transistor $T_3$, i.e., the output end of the second inverter $INV_2$, is connected to the gate of the first n-MOS transistor $T_1$ in the C-MOS inverter 1. The connecting point between the first p-MOS transistor $Q_1$ and the first n-MOS transistor $T_1$ is connected to the ouput end 4. In order to obtain a time lag between the output voltages A and B of the outputs of the first and second inverters $INV_1$ and $INV_2$, the mutual conductance gm of the second n-MOS transistor $T_2$ is made smaller than that of the third n-MOS transistor $T_3$, or the mutual conductance gm of the second P-MOS transistor $Q_2$ is made greater than that of the third P-MOS transistor $Q_3$.

During the transition period when the input voltage C at the input end 3 falls from the power supply voltage (H level) to the ground voltage (L level), when the input voltage C becomes lower than the threshold voltages of the p-MOS

transistors $Q_2$ and $Q_3$, the p-MOS transistors $Q_2$ and $Q_3$ are turned from their nonconductive states to their conductive states. When the input voltage becomes lower than the threshold voltages of the n-MOS transistors $T_2$ and $T_3$, the n-MOS transistors $T_2$ and $T_3$ are turned from their conductive states to their nonconductive states.

Since the mutual conductance gm of the p-MOS transistor $Q_2$ is made greater than that of the p-MOS transistor $Q_3$, the output voltage A rises earlier than the output voltage B, as illustrated in Fig. 2. The output voltages A and B are applied to the gates of the p-MOS transistor $Q_1$ and n-MOS transistor $T_1$ in the C-MOS inverter, respectively. The time lag of the output voltage B from the output voltage A during rising is $\tau_0$.

If the time lag $\tau_0$ could be made great, the p-MOS transistor $Q_1$ and n-MOS transistor $T_1$ in the C-MOS inverter 1 would not be simultaneously turned on. However, since the time lag $\tau_0$ is usually too small, as illustrated in Fig. 2, there is an instant when both p-MOS transistor $Q_1$ an n-MOS transistor $T_1$ are turned on. That is, as shown in Fig. 2, $t_1$ is the time the output voltage B of the second inverter $INV_2$ reaches the threshold voltage $V_{TH1}$ of the n-MOS transistor $T_1$ in the C-MOS inverter 1 and turns the n-MOS transistor $T_1$ from a nonconductive state to a conductive state. Now, $t_2$ is the time shortly after the time $t_1$ when the output voltage A of the first inverter $INV_1$ reaches the threshold voltage $V_{TH2}$ of the p-MOS transistor $Q_1$ in the C-MOS inverter 1 and turns the p-MOS transistor $Q_1$ from a conductive state to a nonconductive state. Therefore, as shown in Fig. 2, during the period between the times $t_1$ and $t_2$, both the p-MOS transistor $W_1$ and the n-MOS transistor $T_1$ in the C-MOS inverter 1 are in their conductive states. As a result, a large current flows from the power supply line $V_{cc}$ through the C-MOS inverter to the ground.

A substantially same discussion as described above applies to rising of the input voltage C. Accordingly, during the time $t_3$ and $t_4$, a large current also flows through the C-MOS inverter.

As mentioned before, a large current flowing through the C-MOS inverter, causes fluctuation of the power supply voltage $V_{cc}$ and ground. This fluctuation of the power supply voltage can cause errors in internal or outer circuits connected to the same power supply line $V_{cc}$ and ground. The problem is especially serious in circuits which require a plurality of C-MOS inverters, from example, in semiconductor memory circuits. In such circuits, the large currents flowing through the C-MOS inverters can accumulate to cause a considerable amount of voltage fluctuation in the power supply line.

Instead of designing the mutual conductance gm of the p-MOS transistor $Q_2$ to be greater than that of the p-MOS transistor $Q_3$, the mutual conductance gm of the n-MOS transistor $T_2$ may be made smaller than that of the n-MOS transistor $T_3$. This design also results in a time lag between the rising or falling waveforms of the output voltages A and B.

In any case, since it is considerably difficult to fabricate an MOS transistor so as to have just the right mutual conductance gm, the rising or falling waveforms of the output voltages of a conventional buffer circuit sometimes become close to each other, as illustrated in Fig. 2. Therefore, when a C-MOS inverter is driven by a conventional buffer circuit, the instantaneous large current can not surely be prevented from flowing through the C-MOS inverter during a transition period.

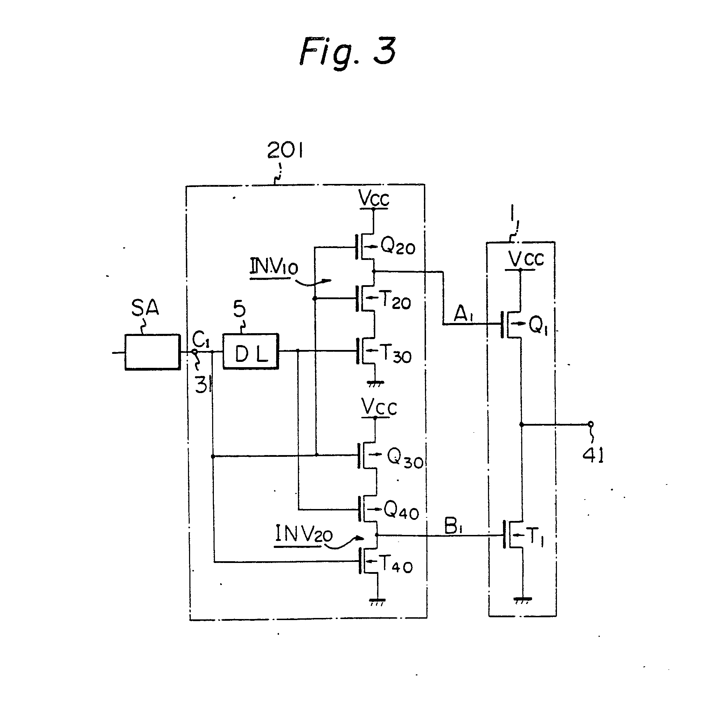

Embodiments of the present invention will now be described. In Fig. 3, a buffer circuit 201 for driving the C-MOS inverter 1 is illustrated. The C-MOS inverter 1 is the same as that in Fig. 1. The buffer circuit 201 of this embodiment comprises a first inverter $INV_{10}$ for driving the first p-MOS transistor $Q_1$ and a second inverter $INV_{20}$ for driving the first n-MOS transistor $T_1$. The first inverter $INV_{10}$ comprises three transistors, i.e., a second p-MOS transistor $Q_{20}$, a second n-MOS transistor $T_{20}$, and a third n-MOS transistor $T_{30}$ connected in series between the power supply line $V_{CC}$ and the ground. The second inverter $INV_{20}$ comprises three transistors, i.e., a third p-MOS transistor $Q_{30}$, a fourth p-MOS transistor $Q_{40}$, and a fourth n-MOS transistor $T_{40}$ connected in series between the power supply line $V_{CC}$ and the ground. A delay circuit 5 is provided between an input end 31 and the gates of the n-MOS transistor $T_{30}$ and the p-MOS transistor $Q_{40}$. The gates of the p-MOS transistor $Q_{20}$ and the n-MOS transistor $T_{20}$ in the first inverter $INV_{10}$, and the gates of the p-MOS transistor $Q_{30}$ and the n-MOS transistor $T_{40}$ in the second inverter $INV_{20}$, are commonly connected to the input end 31. The gate of the n-MOS transistor $T_{30}$ in the first inverter $INV_{10}$ and the gate of the p-MOS transistor $Q_{40}$ are commonly connected to the output of the delay circuit 5. The input end 31 may be connected through the sense amplifier SA to a memory circuit (not shown). The output of the first inverter $INV_{10}$, i.e., the connecting point between the p-MOS transistor $Q_{20}$ and the n-MOS transistor $T_{20}$, is connected to the gate of the p-MOS transistor $Q_1$ in the C-MOS inverter 1. The output of the second inverter $INV_{20}$, i.e., the connecting point between the p-MOS transistor $Q_{40}$ and the n-MOS transistor $T_{40}$, is connected to the gate of the n-MOS transistor $T_1$ in the C-MOS inverter 1. The output of the C-MOS inverter 1, i.e., the connecting point between the p-MOS transistor $Q_1$ and the n-MOS transistor $T_1$, is connected to an output terminal 41.

The main differences between the circuit of Fig. 1 and the circuit of Fig. 3 are that, in Fig. 3, the pull-down portion of the first inverter $INV_{10}$ includes the additional n-MOS transistor $T_{30}$; the pull-up portion of the second inverter $INV_{20}$ includes the additional p-MOS transistor $Q_{40}$; and the buffer circuit 30 includes the additional delay circuit 5. In this embodiment, it is not necessary to have different mutual conductances in the transistors in the buffer circuit 201, in order only to prevent an instantaneous large current flowing through the inverter 1. Therefore, all the mutual conductances of $Q_{20}$, $T_{20}$, $T_{30}$, $Q_{30}$, $Q_{40}$ and $T_{40}$ can be determined only for the speed of driving the inverter.

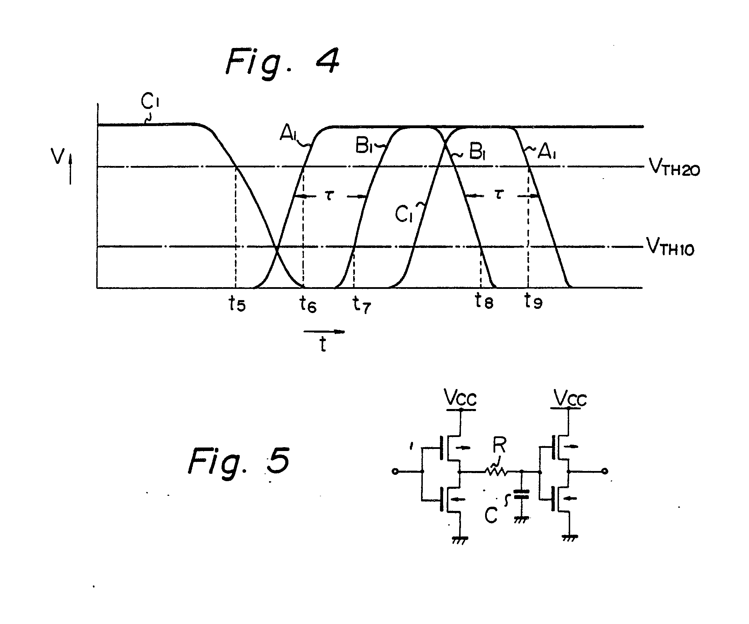

The operation of the circuit of Fig. 3 is now described with reference to Fig. 4. During the transition period when the input voltage $C_1$ at the input end 31 falls from the H level to the L level, when the input voltage $C_1$ at the input end 31 reaches the threshold voltage $V_{TH20}$ of the p-MOS transistors at a time $t_5$, the p-MOS transistors $Q_{20}$ and $Q_{30}$, the gates of which are directly connected to the input end 31, are turned from their non-conductive states to their conductive states. When the input voltage $C_1$ further decreases to reach the threshold voltage $V_{TH10}$ of the n-MOS transistors, the n-MOS transistors $T_{20}$ and $T_{40}$, the gates of which are directly connected to the input end 31, are turned from their conductive states to their nonconductive states. In the first inverter $INV_{10}$, after the input voltage $C_1$ becomes lower than the threshold voltage $V_{TH10}$, the p-MOS transistor $Q_{20}$ is in the conductive state and the n-MOS transistor $T_{20}$ is in the non-conductive state. Therefore, the output voltage $A_1$ of the first inverter $INV_1$ begins to rise. At a time $t_6$, when the output voltage A1 reaches the threshold voltages $V_{TH20}$ of the p-MOS transistor $Q_1$, the p-MOS transistor $Q_1$ is turned from on to off. On the other hand, in the seccond inverter $INV_{20}$, even at the time $t_5$, the p-MOS transistor $Q_{40}$ is not turned on because its gate receives the delayed input voltage from the delay circuit 5. Therefore, the output voltage $B_1$ begins to rise with a delay time after the rising of the output voltage $A_1$ of the first inverter $INV_{10}$. At a time $t_7$, when the output voltage $B_1$ reaches the threshold voltage $V_{TH10}$ of the n-MOS transistor $T_1$, the n-MOS transistor $T_1$ is turned from off to on. As a result, the output voltage at the output end of the C-MOS inverter 1 is turned from the H level to the L level. Before the time $t_6$, only the p-MOS transistor $Q_1$ is in the conductive state. In the period between the time $t_6$ and $t_7$, both p-MOS transistor $Q_1$ and n-MOS transistor $T_1$ are in the nonconductive state. After the time $t_7$, only the n-MOS transistor $T_1$ is in the conductive state. Accordingly, during the transition when the input voltage $C_1$ falls, no momentary current flows from the power supply line $V_{CC}$ through the p-MOS transistor $Q_1$ and n-MOS transistor $T_1$ to the ground.

During the rising of the input voltage $C_1$ the n-MOS transistor $T_{30}$ in the first inverter $INV_{10}$ is turned on at the predetermined delay time $\tau$ after the n-MOS transistor $T_{40}$ in the second inverter $INV_{20}$ is turned on. Therefore, the output voltage $A_1$ of the first inverter $INV_{10}$ falls with the delay time $\tau$ after the fall of the output voltage $B_1$ of the second inverter $INV_{20}$. The n-MOS transistor $T_1$ is turned off at a time $t_8$. After the time $t_8$, the p-MOS transistor $Q_1$ is turned on a time $t_9$. Before the time $t_8$, only the n-MOS transistor $T_1$ is in the conductive state. Between the time $t_8$ and $t_9$, both p-MOS transistor $Q_1$ and n-MOS transistor $T_1$ are in the nonconductive states. After the time $t_9$, only

the p-MOS transistor $Q_1$ is in the conductive state. Accordingly, no current flows through the C-MOS inverter 1 during the rising of the input voltage $C_1$.

Figure 5 shows an example of a well-known delay circuit adaptable to the delay circuit 5 in Fig. 3. The delay circuit of Fig. 5 comprises two inverters and a time constant circuit with a resistor R and a capacitor C. The resistance and the capacitance are appropriately determined so as to obtain the desired delay time τ.

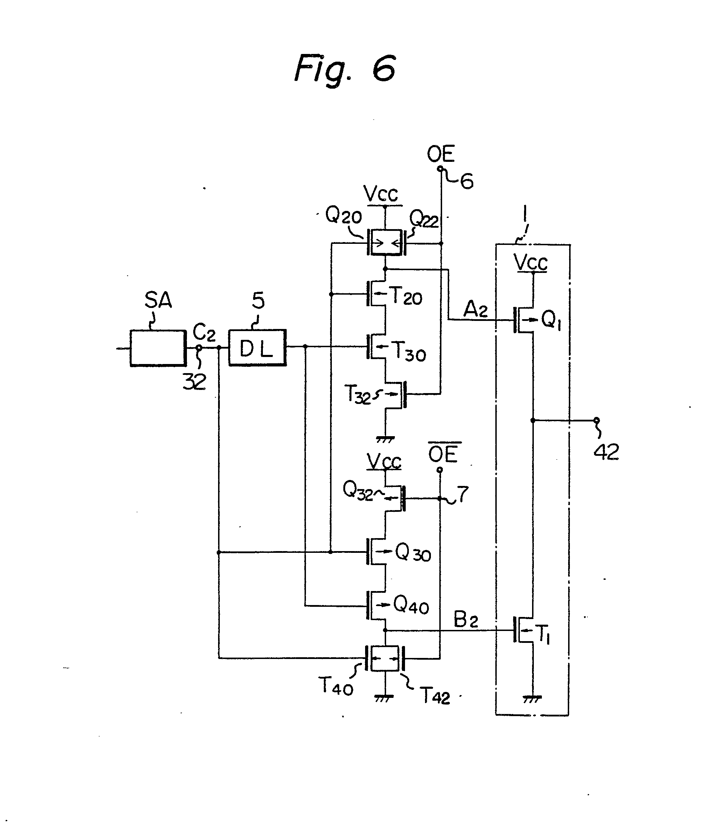

The number of transistors in each inverter in the buffer circuit may alternatively be four or more so as to realize three states, i.e., the L level, the H level, and a high impedance state, at the output of the C-MOS inverter 1. Figure 6 shows a buffer circuit for realizing the three states at the output of a memory circuit. The main difference between Fig. 3 and Fig. 6 is that, in Fig. 6, additional transistors $Q_{22}$, $T_{32}$, $Q_{32}$, and $T_{42}$ are provided. The p-MOS transistor $Q_{22}$ is connected in parallel to the p-MOS transistor $Q_{20}$. The n-MOS transistor $T_{32}$ is inserted between the n-MOS transistor $T_{30}$ and the ground. The p-MOS transistor $Q_{32}$ is inserted between the power supply line $V_{cc}$ and the p-MOS transistor $Q_{30}$. The n-MOS transistor $T_{42}$ is connected in parallel to the n-MOS transistor $T_{40}$. The gates of the p-MOS transistor $Q_{22}$ and the n-MOS transistor $T_{32}$ are commonly connected to a terminal 6 which operatively receives a noninverted output enable signal. The gates of the p-MOS transistor $Q_{32}$ and the N-MOS transistor $T_{42}$ are commonly connected to another terminal 7 which operatively receives an inverted output enable signal.

In a standby state of the memory circuit, the output enable signal OE is at the L level, and the inverted output enable signal $\overline{OE}$ is at the H level. Therefore, the p-MOS transistor $Q_{22}$ is on, and the n-MOS transistor $T_{32}$ is off, so that the output voltage $A_2$ is at the H level regardless of the input voltage $C_2$. Accordingly, the p-MOS transistor $Q_1$ is off regardless of the input voltage $C_2$. Also, the p-MOS transistor $Q_{32}$ is off and the n-MOS transistor $T_{42}$ is on, so that the output voltage $B_2$ is at the L level regardless of the input voltage $C_2$. Consequently, the output of the inverter 1 is at a high impedance.

In an active state of the memory circuit, the output enable signal OE is at the H level, and the inverted output enable signal OE is at the L level. Therefore, the p-MOS transistor $Q_{22}$ is off, and the n-MOS transistor $T_{32}$ is on, so that the output voltage $A_2$ is at the H level or the L level depending on the L level or the H level of the input voltage $C_1$ respectively. Also, the p-MOS transistor $Q_{32}$ is on, and the N-MOS transistor $T_{42}$ is off, so that the output voltage $B_2$ is at the H level or the L level depending on the L level or the H level of the input voltage $C_2$ respectively. The delay circuit 5 in Fig. 6 also gives a perdetermined delay to the rising and the falling of the output voltages $A_2$ and $B_2$, in a similar way as in the circuit of Fig. 3.

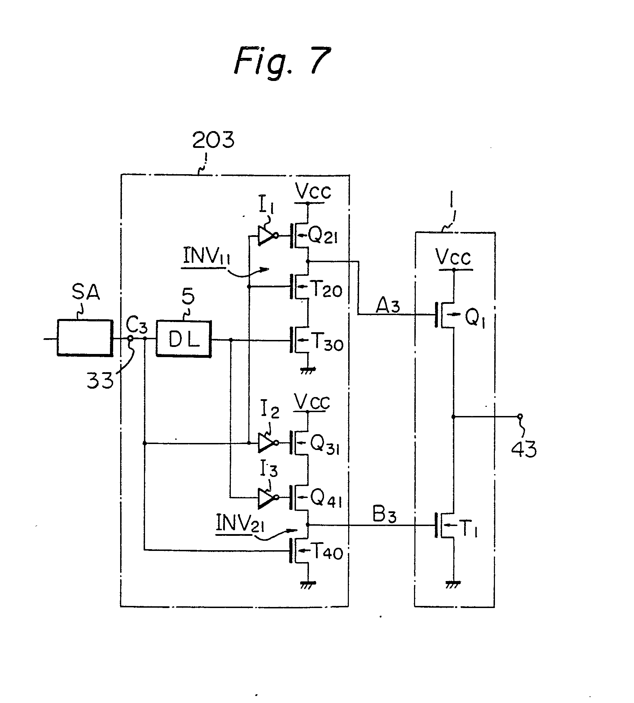

In Fig. 7, still another embodiment of a buffer circuit is illustrated. In this embodiment, the buffer circuit 203 is composed of n-MOS transistors. No p-MOS transistor is used in this buffer circuit 203. In place of the p-MOS transistors $Q_{20}$, $Q_{30}$, and $Q_{40}$ in Fig. 3, n-MOS transistors $Q_{21}$, $Q_{31}$, and $Q_{41}$ are used in Fig. 7, respectively. Between the gate of the n-MOS transistor $Q_{21}$ and the input end 33, a first inverter $I_1$ is inserted. Between the gate of the n-MOS transistor $Q_{31}$ and the input end 33, a second inverter $I_2$ is inserted. Between the gate of the n-MOS transistor $Q_{41}$ and the output of the delay circuit 5, a third inverter $I_3$ is inserted.

This construction enables a similar effect to be obtained as in the circuit of Fig. 3, as will be apparent to those skilled in the art.

The present invention is not restricted to the above-mentioned embodiments. For example, the gates of the n-MOS transistors $T_{20}$ and $T_{30}$ may alternatively be connected to the output of the delay circuit 5 and to the input end 3, respectively. Also the gates of the p-MOS transistors $Q_{30}$ and $Q_{40}$ may alternatively be connected to the output of the delay circuit 5 and to the input end 3, respectively. Further, the input signal of the buffer circuit may be supplied not only from a sense amplifier in a memory circuit but also from any other logic circuit.

From the foregoing description, it will be apparent that, in embodiments as described, since each of the two inverters for driving a p-MOS transistor and an n-MOS transistor in a C-MOS inverter consists of at least three transistors and since a delay circuit is inserted between an input end and the inverters, a desired delay time can be given to the driving timings of the transistors in the C-MOS inverter. As a result, simultaneous conduction of current through the transistors in the C-MOS inverter during its transition state can be prevented. Therefore, the voltage fluctuation of the power supply line, to which the C-MOS inverter and internal or outer circuits of the C-MOS inverter are connected, is suppressed. Further, power consumption in the C-MOS inverter can be reduced.

## Claims

1. A buffer circuit (201), for driving a C-MOS inverter (1) which comprises two transistors ($Q_1$, $T_1$) connected together in series,

the said buffer circuit comprising first and second inverters ($INV_{10}$ and $INV_{20}$), for inverting an input signal ($C_1$) and driving respectively the said two transistors of the C-MOS inverter (1), each of the said first and second inverters comprising a pull-up portion ($Q_{20}$, $Q_{30}$) and a pull-down portion ($T_{20}$, $T_{40}$), connected in series with one another between first and second power supply lines, and having an output point between its pull-up portion and its pull-down portion, the said output point of the said first inverter ($INV_{10}$) being connected to a gate of one of the said two transistors of the C-MOS inverter (1), and the said output point of the said second inverter ($INV_{20}$)

being connected to a gate of the other of the said two transistors of the C-MOS inverter (1), characterised in that,

the said first inverter ($INV_{10}$) further comprises a switching transistor ($T_{30}$) connected, in series with the said pull-down portion ($T_{20}$) of that inverter, between the said second power supply line and the said output point of that inverter ($INV_{10}$),

the said second inverter ($INV_{20}$) further comprises a switching transistor ($Q_{40}$) connected, in series with the said pull-up portion ($Q_{30}$) of that inverter, between the said first power supply line and the said output point of that inverter ($INV_{20}$),

and the said buffer circuit further comprises a delay circuit (5) which is connected to apply, to the switching transistors of the first and second inverters, respective control signals derived from the said input signal but delayed with respect thereto by a predetermined delay time such as to prevent simultaneous conduction of current through the said two transistors ($Q_1$, $T_1$) of the C-MOS inverter (1).

2. A buffer circuit as set forth in the claim 1, wherein the said two transistors ($Q_1$, $T_1$) of the C-MOS inverter (1) are a p-MOS transistor ($Q_1$) and an n-MOS transitor ($T_1$); the p-MOS transistor ($Q_1$) being driven by the output ($A_1$) of the said first inverter, and the n-MOS transistor ($T_1$) being driven by the output ($B_1$) of the said second inverter; and each of the said first and second inverters comprises at least two transistors connected in series with its said switching transistor.

3. A buffer circuit as set forth in claim 1 or 2, wherein said first inverter comprises a first p-MOS transistor ($Q_{20}$) connected to said first power supply line and a first n-MOS transistor ($T_{20}$) connected in series with said first p-MOS transistor, the said output point of the first inverter being between said first p-MOS transistor and said first n-MOS transistor, and the switching transistor of the first inverter being a second n-MOS transistor ($T_{30}$) connected between said first n-MOS transistor ($T_{20}$) and said second power supply line; and

said second inverter comprises a second p-MOS transistor ($Q_{30}$) connected to said first power supply line and a third n-MOS transistor ($T_{40}$) connected to said second power supply line, the said switching transistor of the second inverter being a third p-MOS transistor ($Q_{40}$) connected between said second p-MOS transistor ($Q_{30}$) and said third n-MOS transistor ($T_{40}$), and the said output point of the second inverter being between said third p-MOS transistor ($Q_{40}$) and said third n-MOS transistor ($T_{40}$).

4. A buffer circuit as set forth in claim 1 or 2, wherein said first inverter comprises a first p-MOS transistor connected to said first power supply line and a first n-MOS transistor connected to said second power supply line, the said switching transistor of the first inverter being a second n-MOS transistor connected between said first p-MOS transistor and said first n-MOS transistor, and the said output point of the first inverter being between said first p-MOS transistor and said second n-MOS transistor; and

said second inverter comprises a third n-MOS transistor connected to said second power supply line and a second p-MOS transistor connected in series with said third n-MOS transistor, the said switching transistor of the second inverter being a third p-MOS transistor connected between said first power supply line and said second p-MOS transistor, and the said output point of the second inverter being between said second p-MOS transistor and said third n-MOS transistor.

5. A buffer circuit as set forth in claim 1 or 2, wherein said first inverter ($INV_{11}$) comprises three n-MOS transistors connected together in series, a first one ($Q_{21}$) of those n-MOS transistors being connected to receive an inverted version of said input signal, the second one ($T_{20}$) of those n-MOS transistors being connected to receive said input signal, and the third one ($T_{30}$) of those n-MOS transistors being the said switching transistor of the first inverter; and

said second inverter ($INV_{21}$) comprises three further n-MOS transistors connected together in series, a first one ($Q_{31}$) of those further n-MOS transistors being connected to receive an inverted version of said input signal, the second one ($Q_{41}$) of those further n-MOS transistors being the said switching transistor of the second inverter, and the third one ($T_{40}$) of said n-MOS transistors being connected to receive said input signal, the control signal applied to the said switching transistor of the second inverter being an inverted version of the control signal applied to the said switching transistor of the first inverter.

**Patentansprüche**

1. Pufferschaltung (201), zum Treiben eines C-MOS-Inverters (1), der zwei miteinander in Reihe miteinander verbundene Transistoren ($Q_1$, $T_1$) umfaßt, welche Pufferschaltung erste und zweite Inverter ($INV_{10}$ und $INV_{20}$) zum Invertieren eines Eingangssignals ($C_1$) und zum jeweiligen Treiben der genannten beiden Transistoren des C-MOS-Inverters (1) umfaßt, wobei jeder der ersten und zweiten Inverter einen pull-up-Abschnitt ($Q_{20}$, $Q_{30}$) und einen pull-down-Abschnitt ($T_{20}$, $T_{40}$) umfaßt, die in Reihe miteinander zwischen ersten und zweiten Energieversorgungsleitungen angeschlossen sind und zwischen ihrem pull-up-Abschnitt und ihrem pull-down-Abschnitt einen Ausganspunkt aufweisen, von denen der Ausgangspunkt des genannten ersten Inverters ($INV_{10}$) mit einem Gate von einem der beiden genannten Transistoren des C-MOS-Inverters (1) verbunden ist, und der Ausgangspunkt des genannten zweiten Inverters ($INV_{20}$) mit einem Gate des anderen der genannten beiden Transistoren des C-MOS-Inverters (1) verbunden ist, dadurch gekennzeichnet, daß

der genannte erste Inverter ($INV_{10}$) ferner einen Schalttransistor ($T_{30}$) umfaßt, der mit dem gennanten pull-down-Abschnitt ($T_{20}$) dieses Inverters, zwischen der genannten zweiten Energieversorgungsleitung und dem Ausgangspunkt dieses Inverters ($INV_{10}$) angeschlossen ist,

der genannte zweite Inverter ($INV_{20}$) ferner einen Schalttransistor ($Q_{40}$) umfaßt, der mit dem genannten pull-up-Abschnitt ($Q_{30}$) dieses Inverters, zwischen der genannten ersten Energieversorgungsleitung und dem genannten Ausgangspunkt dieses Inverters ($INV_{20}$) angeschlossen ist,

und die genannte Pufferschaltung ferner eine Verzögerungsschaltung umfaßt, die angeschlossen ist, um den Schalttransistoren der ersten und zweiten Inverter jeweilige Steuersignale zuzuführen, die von dem genannten Eingangssignal abgeleitet, jedoch bezüglich diesem um eine vorbestimmte Verzögerungszeit verzögert sind, um so eine gleichzeitige Stromleitung durch die genannten beiden Transistoren ($Q_1$, $T_1$) des C-MOS-Inverters (1) zu verhindern.

2. Pufferschaltung nach Anspruch 1, bei welcher die genannten beiden Transistoren ($Q_1$, $T_1$) des C-MOS-Inverters (1) ein p-MOS-Transistor ($Q_1$) und ein n-MOS-Transistor ($T_1$) sind; der p-MOS-Transistor ($Q_1$) von dem Ausgang ($A_1$) des genannten ersten Inverters getrieben wird und der n-MOS-Transistor ($T_1$) von dem Ausgang ($B_1$) des genannten zweiten Inverters getrieben wird; und sowohl der erste als auch der zweite Inverter wenigstens zwei Transistoren umfassen, die mit ihrem genannten Schalttransistor in Reihe verbunden sind.

3. Pufferschaltung nach Anspruch 1 oder 2, bei welcher der genannte erste Inverter einen ersten p-MOS-Transistor ($Q_{20}$) umfaßt, der mit der genannten ersten Energieversorgungsleitung verbunden ist, und einen ersten n-MOS-Transistor ($T_{20}$), der mit dem genannten ersten p-MOS-Transistor in Reihe verbunden ist, der genannte Ausgangspunkt des ersten Inverters zwischen dem genannten ersten p-MOS-Transistor und dem genannten ersten n-MOS-Transistor ist, und der Schalttransistor des ersten Inverters ein zweiter n-MOS-Transistor ($T_{30}$) ist, der zwischen dem genannten ersten n-MOS-Transistor ($T_{20}$) und der genannten zweiten Energieversorgungsleitung angeschlossen ist; und

der genannte zweite Inverter einen zweiten p-MOS-Transistor ($Q_{30}$), der mit der genannten ersten Energieversorgungsleitung verbunden ist, und einen dritten n-MOS-Transistor ($T_{40}$), der mit der genannten Zweiten Energieversorgungsleitung verbunden ist, umfaßt, der genannte Schalttransistor des zweiten Inverters ein dritter n-MOS-Transistor ($Q_{40}$) ist, der zwischen dem genannten zweiten p-MOS-Transistor ($Q_{30}$) und dem genannten dritten n-MOS-Transistor ($T_{40}$) verbunden ist, und der genannte Ausgangspunkt des zweiten Inverters zwischen dem genannten dritten p-MOS-Transistor ($Q_{40}$) und dem genannten dritten n-MOS-Transistor ($T_{40}$) liegt.

4. Pufferschaltung nach Anspruch 1 oder 2, bei welcher der genannte erste Inverter einen ersten p-MOS-Transistor umfaßt, der mit der genannten ersten Energieversorgungsleitung verbunden ist, und einen ersten n-MOS-Transistor, der mit der genannten zweiten Energieversorgungsleitung verbunden ist, der genannte Schalttransistor des ersten Inverters ein zweiter n-MOS-Transistor ist, der zwischen dem genannten ersten p-MOS-Transistor und dem genannten ersten n-MOS-Transistor verbunden ist, und der genannte Ausgangspunkt des ersten Inverters zwischen dem genannten ersten p-MOS-Transistor und dem genannten zweiten n-MOS-Transistor liegt; und

der genannte zweite Inverter einen dritten n-MOS-Transistor umfaßt, der mit der genannten zweiten Energieversorgungsleitung verbunden ist, und einen zweiten p-MOS-Transistor, der mit dem genannten dritten n-MOS-Transistor in Reihe verbunden ist, der genannte Schalttransistor des zweiten Inverters ein dritter p-MOS-Transistor ist, der zwischen der genannten ersten Energieversorgungsleitung und dem genannten zweiten p-MOS-Transistor angeschlossen ist, und der genannte Ausgangspunkt des zweiten Inverters zwischen dem genannten zweiten p-MOS-Transistor und dem gennanten dritten n-MOS-Transistor liegt.

5. Pufferschaltung nach Anspruch 1 oder 2, bei welcher der genannte erste Inverter ($INV_{11}$) drei n-MOS-Transistoren umfaßt, die miteinander in Reihe verbunden sind, ein erster ($Q_{21}$) dieser n-MOS-Transistoren angeschlossen ist, um eine invertierte Version des genannten Eingangssignals zu empfangen, der zweite ($T_{20}$) dieser n-MOS-Transistoren angeschlossen ist, um das genannte Eingangssignal zu empfangen, und der dritte ($T_{30}$) dieser n-MOS-Transistoren der genannte Schalttransistor des ersten Inverters ist; und

der genannte zweite Inverter ($INV_{21}$) drei weitere n-MOS-Transistoren umfaßt, die miteinander in Reihe verbunden sind, ein erster ($Q_{31}$) dieser weiteren n-MOS-Transistoren angeschlossen ist, um eine invertierte Version des genannten Eingangssignals zu empfangen der zweite ($Q_{41}$) dieser weiteren n-MOS-Transistoren der genannte Schalttransistor des zweiten Inverters ist und der dritte ($T_{40}$) der genannten n-MOS-Transistoren angeschlossen ist, um das genannte Eingangssignal zu empfangen, wobei das Steuersignal, welches dem genannten Schalttransistor des zweiten Inverters zugeführt wird, eine invertierte Version des Steuersignals ist, welches dem genannten Schalttransistor des ersten Inverters zugeführt wird.

**Revendications**

1. Circuit tampon (201), destiné à commander un inverseur C-MOS (1) qui comprend deux transistors ($Q_1$, $T_1$) connectés ensemble en série,

le circuit tampon comprenant des premier et second inverseurs ($INV_{10}$, $INV_{20}$), pour inverser un signal d'entrée ($C_1$) et pour commander respectivement les deux transistors de l'inverseur C-MOS (1), chacun des premier et second inverseurs comprenant une partie élévatrice ($Q_{20}$, $Q_{30}$)

et une partie chutrice ($T_{20}$, $T_{40}$), connectées en série entre elles entre des première et seconde lignes d'alimentation, et comportant un point de sortie entre sa partie élévatrice et sa partie chutrice, le point de sortie du premier inverseur ($INV_{10}$) étant connecté à une grille de l'un des deux transistors de l'inverseur C-MOS (1), et le point de sortie du second inverseur ($INV_{20}$) étant connecté à une grille de l'autre des deux transistors de l'inverseur C-MOS (1), caractérisé en ce que:

le premier inverseur ($INV_{10}$) comprend en outre un transistor de commutation ($T_{30}$) connecté, en série avec la partie chutrice ($T_{20}$) de cet inverseur, entre la seconde ligne d'alimentation et le point de sortie de cet inverseur ($INV_{10}$),

le second inverseur ($INV_{20}$) comprend en outre un transistor de commutation ($Q_{40}$) connecté, en série avec la partie élévatrice ($Q_{30}$) de cet inverseur, entre la première ligne d'alimentation et le point de sortie de cet inverseur ($INV_{20}$),

et en ce que le circuit tampon comprend en outre un circuit à retard (5) qui est connecté pour appliquer, aux transistors de commutation des premier et second inverseurs, des signaux de commande respectifs dérivés du signal d'entrée mais retardés par rapport à celui-ci d'un retard de temps prédéterminé de manière à empêcher une conduction simultanée de courant dans les deux transistors ($Q_1$, $T_1$) de l'inverseur C-MOS (1).

2. Circuit tampon selon la revendication 1, das lequel les deux transistors ($Q_1$, $T_1$) de l'inverseur C-MOS (1) sont un transistor p-MOS ($Q_1$) et un transistor n-MOS ($T_1$); le transistor p-MOS ($Q_1$) étant commandé par le signal de sortie ($A_1$) du premier inverseur, et le transistor n-MOS ($T_1$) étant commandé par le signal de sortie ($B_1$) du second inverseur; et chacun des premier et second inverseurs comprend au moins deux transistors connectés en série avec son transistor de commutation.

3. Circuit tampon selon l'une quelconque des revendications 1 et 2, dans lequel le premier inverseur comprend un premier transistor p-MOS ($Q_{20}$) connecté à la première ligne d'alimentation et un premier transistor n-MOS ($T_{20}$) connecté en série avec le premier transistor p-MOS, le point de sortie du premier inverseur étant entre le premier transistor p-MOS et le premier transistor n-MOS, et le transistor de commutation du premier inverseur étant un deuxième transistor n-MOS ($T_{30}$) connecté entre le premier transistor n-MOS ($T_{20}$) et la seconde ligne d'alimentation; et

le second inverseur comprend un deuxième transistor p-MOS ($Q_{30}$) connecté à la première ligne d'alimentation et un troisième transistor n-MOS ($T_{40}$) connecté à la seconde ligne d'alimentation, le transistor de commutation du second inverseur étant un troisième transistor p-MOS ($Q_{40}$) connecté entre le deuxième transistor p-MOS ($Q_{30}$) et le troisième transistor n-MOS ($T_{40}$), et le point de sortie du second inverseur étant entre le troisième transistor p-MOS ($Q_{40}$) et le troisième transistor n-MOS ($T_{40}$).

4. Circuit tampon selon l'une quelconque des revendications 1 et 2, dans lequel le premier inverseur comprend un premier transistor p-MOS connecté à la première ligne d'alimentation et un premier transistor n-MOS connecté à la seconde ligne d'alimentation, le transistor de commutation de premier inverseur étant un deuxième transistor n-MOS connecté entre le premier transistor p-MOS et le premier transistor n-MOS, et le point de sortie du premier inverseur étant entre le premier transistor p-MOS et le deuxième transistor n-MOS; et

le second inverseur comprend un troisième transistor n-NOS connecté à la seconde ligne d'alimentation et un deuxième transistor p-MOS connecté en série avec le troisième transistor n-MOS, le transistor de commutation du second inverseur étant un troisième transistor p-MOS connecté entre la première ligne d'alimentation et le deuxième transistor p-MOS, et le point de sortie du second inverseur étant entre le deuxième transistor p-MOS et le troisième transistor n-MOS.

5. Circuit tampon selon l'une quelconque des revendications 1 et 2, dans lequel le premier inverseur ($INV_{11}$) comprend trois transistors n-MOS connectés ensemble en série, un premier ($Q_{21}$) de ces transistors n-MOS étant connecté pour recevoir une version inversée du signal d'entrée, le deuxième ($T_{20}$) de ces transistors n-MOS étant connecté pour recevoir le signal d'entrée, et le troisième ($T_{30}$) de ces transistor n-MOS étant le transistor de commutation du premier inverseur; et

le second inverseur ($INV_{21}$) comprend trois autres transistors n-MOS connectés ensemble en série, un premier ($Q_{31}$) de ces autres transistors n-MOS étant connecté pour recevoir une version inversée du signal d'entrée, le deuxième ($Q_{41}$) de ces autres transistors n-MOS étant le transistor de commutation du second inverseur, et le troisième ($T_{40}$) des transistors n-MOS étant connecté pour recevoir le signal d'entrée, le signal de commande appliqué au transistor de commutation du second inverseur étant une version inversée du signal de commande appliqué au transistor de commutation du premier inverseur.

*Fig. 1*

*Fig. 2*

1

## Fig. 3

# Fig. 4

# Fig. 5

# Fig. 6

## Fig. 7